# EUROPÄISCHE PATENTSCHRIFT

(11) **EP 2 561 113 B1**
(45) Veröffentlichungstag und Bekanntmachung des Hinweises auf die Patenterteilung: **22.10.2014**
(21) Anmeldenummer: 11743416.7
(22) Anmeldetag: 20.04.2011
(51) Int. Cl.: H01J 37/20, C23C 14/24, C23C 14/30, H01J 37/305

(54) **VORRICHTUNG ZUM BESCHICHTEN VON SUBSTRATEN NACH DEM EB/PVD-VERFAHREN**
APPARATUS FOR COATING SUBSTRATES USING THE EB/PVD METHOD
DISPOSITIF DE REVÊTEMENT DE SUBSTRATS SELON LE PROCÉDÉ DE DÉPÔT PAR ÉVAPORATION SOUS BOMBARDEMENT ÉLECTRONIQUE

(30) Priorität: 21.04.2010 DE 102010017895
(43) Veröffentlichungstag der Anmeldung: 27.02.2013
(73) Patentinhaber: Ald Vacuum Technologies GmbH, 63450 Hanau (DE)
(72) Erfinder: HOTZ, Jürgen, 64839 Münster (DE); SESERKO, Pavel, 63791 Karlstein (DE); WITTICH, Jörg, 64853 Otzberg (DE); EBERHARDT, Helmut, 63584 Gründau (DE); KIRSCHNER, Manfred, 64720 Michelstadt (DE); RIETH, Wolfgang, 63571 Gelnhausen (DE)
(74) Vertreter: Hebing, Norbert
(86) Internationale Anmeldenummer: PCT/DE2011/000434
(87) Internationale Veröffentlichungsnummer: WO 2011/131171

(56) Entgegenhaltungen:
- DE-A1-102004 006 849

## Beschreibung

Die Erfindung bezieht sich auf eine Vorrichtung zum Beschichten von Substraten mit einem Beschichtungsmaterial nach dem EB/PVD-Verfahren mit einer aus wenigstens zwei in einer Horizontalebene versetzt zueinander angeordneten Tiegeln bestehenden Tiegelanordnung, die in einem horizontal versetzbaren Gestell angeordnet sind, wobei in dem Gestell unterhalb eines jeden Tiegels wenigstens ein Schacht zur Aufnahme einer aus dem Beschichtungsmaterial bestehenden Materialstange angeordnet ist, und mit mindestens einer Hubeinrichtung, mit deren Hilfe eine in dem Schacht angeordnete Materialstange durch den Boden des Tiegels in den Tiegel einführbar ist, um dort durch den Beschuss mit einem Elektronenstrahl aus einer Elektronenkanone verdampft zu werden.

Eine derartige Anordnung ist der DE 10 2004 006 848 A1 beschrieben: Am Kopf eines Drehgestells sind zwei Paar Tiegel symmetrisch angeordnet, so dass durch eine 180°-Drehung des Drehgestells die Tiegel des einen Paares kreuzweise ihren Platz mit den Tiegeln des anderen Paares tauschen. Unterhalb eines jeden Tiegels befindet sich ein Karussell mit mehreren Schächten, in denen Materialstangen bevorratet werden. Jede Materialstange besteht aus mehreren kurzen vollzylindrischen Teilstücken. Ist eine Materialstange im Tiegel bis auf das letzte Teilstück aufgebraucht, wird dieses im Tiegel eingeklemmt, so dass sich das Karussell unter dem Tiegel soweit ungehindert drehen kann, bis sich wieder ein gefüllter Schacht des Karussells unter dem Tiegel befindet. Die Hubeinrichtung schiebt die neue Materialstange gegen das im Tiegel verbliebene Teilstück, dessen Klemmung danach aufgehoben wird. Da das nachgeschobene Material dem Material des verbliebenen Teilstückes entsprechen muss, wird ein Karussell mit Materialstangen aus einem Material bestückt.

Die Hubeinrichtung in der bekannten Vorrichtung besteht aus Spindelantrieben, die an der wand der Vakuumkammer befestigt sind, in der die Vorrichtung angeordnet ist.

Die Anordnung von insgesamt vier Tiegeln mit den zugehörigen Karussells auf einem Gestell schafft eine Anordnung, die insbesondere bei einer großen Beladung mit Material nur in einem großen Einbauraum auf einer Hochachse drehbar gelagert werden kann. Die außen um das Gestell angeordneten Hubeinrichtungen vergrößern den Einbauraum nochmals, so dass eine große Vakuumkammer zur Verfügung gestellt werden muss

Die Erfindung beruht auf der Aufgabe, eine kompakte Anlage zu schaffen, die auch bei einer hohen Beladung mit Material störungsfrei arbeitet.

Zur Lösung des Problems sieht daher die Erfindung vor, dass jedem Tiegel ein Hubeinrichtung zugeordnet ist, die in dem Gestell angeordnet ist, und dass das Gestell in Richtung des Versatzes der Tiegel linear verschiebbar ist.

Die erfindungsgemäße Vorrichtung hat den Vorteil, dass eine lineare Führung bei gleicher Präzision ist weniger Einbauraum benötigt als eine Drehanordnung, so dass auch die Hubeinrichtungen auf dem Gestell angeordnet werden können. Sie stehen damit in einem festen räumlichen Verhältnis zu den Karussells, so dass ein präzises Zusammenwirken der Hubeinrichtung mit dem jeweils zugeordneten Karussell gewährleistet ist.

Die Karussells können nun mit unterschiedlichen Materialien für verschiedene Substratschichten gefüllt werden. Die einzelnen Schichten werden sukzessive aufgebracht, indem das Gestell linear verschoben wird, so dass sich jeweils der Tiegel mit dem aktuell zu verdampfenden Material in einer Arbeitsposition befindet, in der er von einem Elektronenstrahl erreichbar ist. Die Lage der Arbeitsposition ist begrenzt, da sich große Teile der Oberseite des Gestells mit dem Tiegel im Schatten der Substrate und deren Halter befinden.

Das Problem der Abschattung tritt auf, weil die Elektronenkanone nur oberhalb einer Beschichtungszone, die oberhalb der Tiegel liegt und in denen sich die zu beschichtenden Substrate befinden, angeordnet werden kann. Da die Substrate und deren Halter die Beschichtungszone weitgehend ausfüllen, verbleibt nur ein beschränkter Raum zur Führung des Elektronenstrahls bis zu den Tiegeln. Eine Substrataufnahme besteht z. B. aus zwei länglichen, horizontal verlaufenden Haltern, an denen nebeneinander mehrere Substrate gehalten sind. Der Elektronenstrahl kann daher nur in einer Vertikalebene bewegt werden, die zwischen den zwei Haltern liegt. Bereiche seitlich dieser Ebene werden durch die Substrataufnahmen abgeschattet. Aus diesem Grund müssen die einzelnen Tiegel, um in ihre Arbeitsposition zu gelangen, in die vertikalebene hinein verschoben werden, damit sie vom Elektronenstrahl erreicht werden können.

Wird das Gestell von einer Endposition in die andere Endposition um eine Wegstrecke, die dem Versatz der Tiegel einer Tiegelanordnung entspricht, linear verfahren, so nimmt der eine Tiegel die Arbeitsposition des anderen Tiegels ein, so dass dieser nun vom Strahl der Elektronenkanone erreichbar ist.

vorzugsweise ist die Tiegelanordnung eine von zwei Tiegelanordnungen, wobei die Tiegel von beiden Tiegelanordnungen denselben Versatz aufweisen, so dass in der Arbeitsposition Material aus jeweils zwei Tiegeln verdampft werden kann.

Um genügend Material zur Verfügung stellen zu können, ohne dass die Vakuumkammer geöffnet werden braucht, ist jedem Tiegel ein Karussell mit mehreren Schächten zugeordnet, wobei jedes Karussell um eine Hochachse drehbar im Gestell gelagert ist.

Ein einfacher und kompakter Aufbau wird erreicht, wenn die Vorrichtung in einer vakuumkammer angeordnet ist, wobei die Antriebswellen für die Hubeinrichtungen durch eine wand der Vakuumkammer vakuumdicht hindurchgeführt sind, so dass sich die Motoren zum Antrieb der einzelnen Hubeinrichtungen außerhalb der Vakuumkammer befinden.

Die Motoren sind ortsfest an der Vakuumkammer angebracht. Damit in jeder Position des Gestells ein Drehmoment auf die Hubeinrichtung übertragen werden kann, weist jede Drehmoment übertragende Verbindung zwischen einem Motor und der dazugehörigen Hubeinrichtung einen teleskopartig ausziehbaren Abschnitt auf.

Die Schächte werden im einfachsten Fall durch in einem Kreis angeordnete Käfigstangen gebildet, die sich zwischen einem oberen und unteren Drehteller erstrecken.

Die Hubeinrichtungen, die als Spindelantriebe ausgebildet sind, besitzen jeweils einen seitlich abstehenden Ausleger, der in den zugehörigen, von Käfigstangen gebildeten Schacht eingreift.

Um zwischen den Schächten eines Gestells wechseln zu können, ist an der Oberseite des Gestells für jeden Tiegel eine Zuführungshülse angeordnet, durch die hindurch eine Materialstange durch den Tiegelboden in den Tiegel einführbar ist. Jede Zuführungshülse ist mit einer Klemmeinrichtung zum Halten der Materialstange in der Zuführungshülse ausgestattet.

Im Folgenden soll anhand eines Ausführungsbeispieles die Erfindung näher erläutert werden. Dazu zeigen:
- Fig.1: eine Gesamtansicht der Vorrichtung, bei der sich ein Gestell mit Tiegeln in einer vorderen Position befindet, und
- Fig.2: eine Gesamtansicht derselbe Vorrichtung, bei der sich das Gestell mit Tiegeln in einer hinteren Position befindet.

Die erfindungsgemäße Anordnung besteht aus einem Gestell 1 mit einer rechteckförmigen Rahmenstruktur, das zwischen zwei Rahmen 2 linear in Richtung des Doppelpfeils verfahrbar angeordnet ist. Jeder Rahmen besteht aus einem Vertikalbalken 3, der über seine Länge an einer hier nicht dargestellten Tür einer Vakuumkammer 4 befestigt ist, sowie aus einem Querbalken 5, der von der Tür horizontal absteht, und einem zwischen dem Vertikal- und dem Querbalken 3, 5 schräg verlaufenden Stützbalken 6. Auf der Oberseite des Querbalkens 5 befindet sich eine Führungsschiene 7.

Auf der Oberseite des Gestells 1 sind zwei Platten 8, 9 geschraubt, auf denen jeweils eine vordere und eine hintere Führungshülse 10, 11 befestigt ist. Auf den Führungshülsen 10, 11 befinden sich hier nicht näher dargestellte vordere und hintere Tiegel zur Aufnahme des zu verdampfenden Materials. Dieses wird in Stangenform durch die Führungshülsen 10, 11 und durch den Boden des zugehörigen Tiegels von unten in den Tiegel eingeführt. Ein vorderer und ein hinterer Tiegel bilden jeweils eine Tiegelanordnung, wobei die Tiegel einer Tiegelanordnung jeweils mit unterschiedlichen Materialien bestückt werden können.

Oberhalb der Tiegel befindet sich eine hier nicht dargestellte Kondensationshaube, die ebenfalls an der hier nicht dargestellten Tür der Vakuumkammer befestigt ist. Die Kondensationshaube umschließt eine Beschichtungszone, in der die Substrate an drehbaren Haltern angeordnet sind, die hier ebenfalls nicht dargestellt sind. Die drehbaren Halter erlauben es, die Substrate in einer verdampfungswolke zu drehen, so dass sie allseitig beschichtet werden.

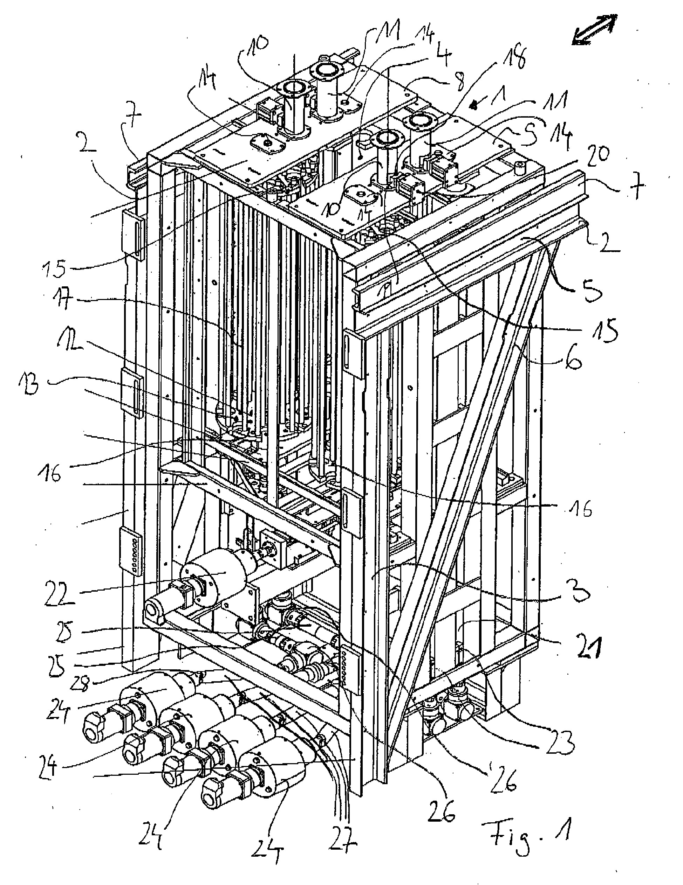

Innerhalb des Gestells 1 - was in der Fig. 1 gut zu erkennen ist - befindet sich unterhalb einer jeden Führungshülse 10, 11 ein Karussell 12 mit mehreren Schächten 13, in denen das zu verdampfende Material in Form von Materialstangen bevorratet wird. Die Schächte 13 sind konzentrisch zu einer Hochachse 14 angeordnet, so dass immer ein Schacht 13 eines Gestells 1 unter die jeweils zugehörige Führungshülse 10, 11 bzw. Tiegel gestellt werden kann. Die Karussells 12 bestehen jeweils aus einem oberen und einem unteren Drehteller 15, 16, zwischen denen Käfigstangen 17 angeordnet sind, die die Schächte 13 begrenzen.

Jede Führungshülse 10, 11 weist eine seitliche Öffnung 18 auf, in der ein Klemmstück 19 mittels eines Linearantriebs 20 einführbar ist. Dies erlaubt es, eine Materialstange in der Führungshülse 10, 11 festzuklemmen.

In den Seitenbereichen des Gestells 1 befinden sich vier Hubeinrichtungen 21 (zwei auf jeder Seite), die mit dem Gestell 1 verfahrbar sind und jeweils einem Karussell 12 zugeordnet sind. Da sowohl die Karussells 12 als auch die Hubeinrichtungen 21 auf dem Gestell 1 angeordnet sind, ist ihre räumliche Zuordnung unverändert, so dass die Hubeinrichtungen 21 präzise in die Schächte 13 zum Anheben der dort vorhandenen Materialstangen eingreifen können.

Um das Gestell 1 hin- und herfahren zu können, besitzt es an den oberen Kanten Rollen, die hier nicht näher dargestellt sind und die in die Führungsschienen 7 eingreifen. Die Kraft zum Verschieben des Gestells 1 wird von einem Motor 22 erzeugt, der an der Außenseite einer Tür der Vakuumkammer 4 befestigt ist und mit einem am Gestell 1 befestigten Spindelantrieb 23 verbunden ist.

Auch die Hubeinrichtungen sind Spindelantriebe, die über weitere Motoren 24 einzeln angetrieben werden. Diese Motoren 24 sind ebenfalls außen an der Tür angebracht und sind mit den Hubeinrichtungen 21 über mehrere Antriebswellen 25 und Umlenker 26 verbunden. Damit das Gestell 1 gegenüber den fest angeordneten Motoren 24 bewegt werden kann, ist jeweils eine Antriebswelle als Teleskopwelle 27 ausgebildet, die unmittelbar über Kardangelenke 28 an den jeweiligen Motor 24 anschließt.

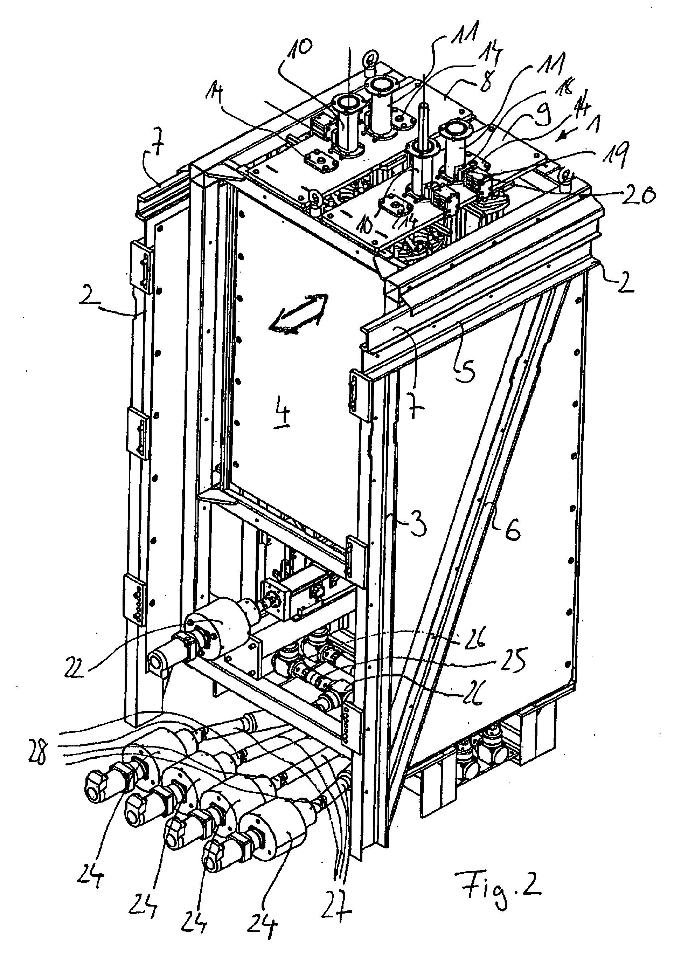

Die Fig. 1 zeigt nun das Gestell 1 in einer hinteren, von der Tür entfernten Position und Fig. 2 das Gestell 1 in einer vorderen, der Tür nahen Position. Bei der in der Fig. 1 dargestellten Position befinden sich die beiden hinteren Führungshülsen 11 und damit die zugehörigen hinteren Tiegel in den Arbeitspositionen.

In der in Fig. 2 dargestellten Position des Gestells nahe der Tür befinden sich die vorderen Tiegel in derselben Arbeitsposition.

Die Tiegel, die sich jeweils in den Arbeitspositionen befinden, sind von den Elektronenstrahlen der Elektronenkanonen, die sich oberhalb des Rahmens befinden, zu erreichen.

Die Substrate können nun mit zwei unterschiedlichen Materialien schichtweise beschichtet werden, die jeweils in den Karussells 12 für die vorderen bzw. hinteren Tiegel bevorratet werden. Bei einem Wechsel zur nächsten Lage, die aus einem anderen Material bestehen als die vorhergehende, wird das Gestell 1 von der einen in die andere Endposition Verfahren, so dass die Tiegel mit dem nun benötigten Material sich in der Arbeitsposition befinden.

Die Anordnung von zwei Tiegelpaaren ist notwendig, um in der Beschichtungszone eine ausgedehnte verdampfungswolke zu schaffen, in denen eine Vielzahl von kleinen Substraten, z. B. Turbinenschaufeln, gleichzeitig beschichtet werden können.

### Bezugszeichenliste

- 1: Gestell
- 2: Rahmen
- 3: Vertikalbalken
- 4: Vakuumkammer
- 5: Querbalken

- 6: Stützbalken
- 7: Führungsschiene
- 8: Platte
- 9: Platte
- 10: vordere Führungshülsen

- 11: hintere Führungshülsen
- 12: Karussell
- 13: Schächte
- 14: Hochachse
- 15: oberer Drehteller

- 16: untere Drehteller
- 17: Käfigstangen
- 18: Öffnung
- 19: Klemmstücke
- 20: Linearantrieb

- 21: Hubeinrichtungen
- 22: Motor
- 23: Spindelantrieb
- 24: Motoren
- 25: Antriebswellen

- 26: Umlenker
- 27: Teleskopwellen
- 28: Kardangelenke

## Patentansprüche

1. Vorrichtung zum Beschichten von Substraten mit einem Beschichtungsmaterial nach dem EB/PVD-Verfahren mit einer aus wenigstens zwei in einer Horizontalebene versetzt zueinander angeordneten Tiegeln bestehenden Tiegelanordnung, die in einem horizontal versetzbaren Gestell (1) angeordnet sind, wobei in dem Gestell (1) unterhalb eines jeden Tiegels wenigstens ein Schacht (13) zur Aufnahme einer aus dem Beschichtungsmaterial bestehenden Materialstange angeordnet ist, und mit mindestens einer Hubeinrichtung (21), mit deren Hilfe eine in dem Schacht (13) angeordnete Materialstange durch den Boden des Tiegels in den Tiegel einführbar ist, um dort durch den Beschuss mit einem Elektronenstrahl aus einer Elektronenkanone verdampft zu werden, **dadurch gekennzeichnet, dass** jedem Tiegel eine Hubeinrichtung (21) zugeordnet ist, die in dem Gestell (1) angeordnet ist, und dass das Gestell (1) in Richtung des Versatzes der Tiegel linear verschiebbar ist.

2. Vorrichtung nach Anspruch 1, **dadurch gekennzeichnet, dass** die Tiegelanordnung eine von zwei Tiegelanordnungen ist, wobei die Tiegel von beiden Tiegelanordnungen denselben Versatz aufweisen.

3. Vorrichtung nach Anspruch 1 oder 2, **dadurch gekennzeichnet, dass** jedem Tiegel ein Karussell (12) mit mehreren Schächten (13) zugeordnet ist, wobei jedes Karussell (12) um eine Hochachse (14) drehbar in dem Gestell (1) gelagert ist.

4. Vorrichtung nach einem der Ansprüche 1 bis 3, **dadurch gekennzeichnet, dass** die Vorrichtung in einer Vakuumkammer (4) angeordnet ist und dass Antriebswellen (25) für die Hubeinrichtungen (21) durch eine Wand der Vakuumkammer (4) vakuumdicht hindurchgeführt sind, so dass sich Motoren (24) zum Antrieb der einzelnen Hubeinrichtungen (21) außerhalb der Vakuumkammer (4) befinden.

5. Vorrichtung nach Anspruch 4, **dadurch gekennzeichnet, dass** jede ein Drehmoment übertragende Verbindung zwischen den Motoren und den Hubeinrichtungen einen teleskopartig ausziehbaren Abschnitt aufweist.

6. Vorrichtung nach Anspruch 3, **dadurch gekennzeichnet, dass** die Schächte (13) durch in einem Kreis angeordnete Käfigstangen (17) gebildet sind, die sich zwischen einem oberen und unteren Drehteller (15, 16) erstrecken.

7. Vorrichtung nach Anspruch 6, **dadurch gekennzeichnet, dass** die Hubeinrichtungen (21), die als Spindelantriebe ausgebildet sind, jeweils einen seitlich abstehenden Ausleger besitzen, der in den durch die Käfigstangen (17) gebildeten Schacht (13) eingreift.

8. Vorrichtung nach einem der vorhergehenden Ansprüche, **dadurch gekennzeichnet, dass** an der Oberseite des Gestells (1) für jeden Tiegel eine Zuführungshülse (10, 11) angeordnet ist, durch die hindurch eine Materialstange durch den Tiegelboden in den Tiegel einführbar ist, und dass jede Zuführungshülse (10, 11) mit einer Klemmeinrichtung zum Halten der Materialstange in der Zuführungshülse (10, 11) ausgestattet ist.

## Claims

1. Apparatus for coating substrates with a coating material using the EB/PVD method having a crucible arrangement comprised of at least two crucibles disposed offset from one another in a horizontal plane, the crucible arrangement being disposed in a frame (1) that can be displaced horizontally, wherein at least one shaft (13) for accommodating a material bar comprised of the coating material is disposed in the frame (1) beneath each crucible, and having at least one lifting device (21), by means of which a material bar disposed in the shaft (13) can be inserted through the base of the crucible into the crucible in order to be vaporized there by bombardment with an electron beam from an electron gun, **characterized in that** each crucible is assigned one lifting device (21), which is disposed in the frame (1), and that the frame (1) can be displaced linearly in the direction of the offset of the crucibles.

2. Apparatus according to Claim 1, **characterized in that** the crucible arrangement is one of two crucible arrangements, wherein the crucibles of both crucible arrangements have the same offset.

3. Apparatus according to Claim 1 or 2, **characterized in that** each crucible is assigned a carousel (12) having several shafts (13), wherein each carousel (12) is rotatably mounted around a vertical axis (14) in the frame (1).

4. Apparatus according to one of Claims 1 to 3, **characterized in that** the apparatus is disposed in a vacuum chamber (4) and that drive shafts (25) for the lifting devices (21) are fed through a wall of the vacuum chamber (4) in a vacuum-tight manner so that the motors (24) for driving the individual lifting devices (21) are situated outside the vacuum chamber (4).

5. Apparatus according to Claim 4, **characterized in that** each connection between the motors and the lifting devices that transmits a torque has a telescopically extendable section.

6. Apparatus according to Claim 3, **characterized in that** the shafts (13) are formed by cage bars (17) arranged in a circle which extend between an upper and a lower rotary disk (15, 16).

7. Apparatus according to Claim 6, **characterized in that** the lifting devices (21), which are configured as spindle drives, each have a laterally projecting extension which engages in the shaft (13) formed by the cage bars (17).

8. Apparatus according to one of the preceding claims, **characterized in that** a feed sleeve (10, 11) is disposed on the upper side of the frame (1) for each crucible, through which a material bar can be inserted through the crucible base into the crucible, and that each feed sleeve (10, 11) is equipped with a clamping device for holding the material bar in the feed sleeve (10, 11).

## Revendications

1. Dispositif de revêtement de substrats avec un matériau de revêtement selon le procédé de dépôt par évaporation sous bombardement électronique avec un agencement de creusets composé d'au moins deux creusets disposés décalés l'un par rapport à l'autre dans un plan horizontal, pour lequel est disposé au moins un puits (13) dans le châssis (1) sous chaque creuset pour recevoir une barre de matériau composée du matériau de revêtement et avec au moins un système de levage (21) à l'aide duquel une barre de matériau disposée dans le puits (13) peut être introduite dans le creuset par le fond du creuset pour y être évaporée par le bombardement avec un faisceau d'électrons d'un canon à électrons **caractérisé en ce qu'**à chaque creuset est attribué un système de levage (21) qui est disposé dans le châssis (1) et **en ce que** le châssis (1) est linéairement mobile dans la direction du déport du creuset.

2. Dispositif selon la revendication 1 **caractérisé en ce que** l'agencement de creusets est un de deux agencements de creusets, les creusets des deux agencements de creusets présentant le même déport .

3. Dispositif selon la revendication 1 ou 2 **caractérisé en ce qu'**à chaque creuset est attribué un carrousel(12) avec plusieurs puits (13), chaque carrousel (12) étant monté rotatif dans le châssis (1) autour d'un axe vertical (14).

4. Dispositif selon une quelconque des revendications 1 à 3 **caractérisé en ce que** le dispositif est disposé dans une chambre de vide (4) et **en ce que** des arbres d'entraînement (25) pour les systèmes de levage (21) sont passés de façon étanche au vide à travers une paroi de la chambre de vide (4) de sorte que les moteurs (24) pour l'entraînement des systèmes de levage (21) individuels se trouvent en dehors de la chambre de vide (4).

5. Dispositif selon la revendication 4 **caractérisé en ce que** chaque liaison transmettant un couple entre les moteurs et les systèmes de levage présente une section extensible de type télescopique.

6. Dispositif selon la revendication 3 **caractérisé en ce que** les puits (13) sont constitués par des barres de cage (17) disposées en cercle qui s'étendent entre un plateau pivotant supérieur et plateau pivotant inférieur (15, 16).

7. Dispositif selon la revendication 6 **caractérisé en ce que** les systèmes de levage (21) qui sont constitués comme des entraînements à vis sans fin, possèdent respectivement une console s'éloignant latéralement qui vient en prise dans le puits (13) formé par les barres de cage (17).

8. Dispositif selon une quelconque des revendications précédentes **caractérisé en ce que** sur le côté supérieur du châssis (1) pour chaque creuset est disposé un manchon d'alimentation (10, 11) à travers lequel on peut introduire une barre de matériau dans le creuset par le fond du creuset et **en ce que** chaque manchon d'alimentation (10, 11) est muni d'un système de serrage pour fixer la barre de matériau dans le manchon d'alimentation (10, 11).
